Europäisches Patentamt

European Patent Office

Office européen des brevets

(11) Veröffentlichungsnummer: **0 321 813**
**A1**

# EUROPÄISCHE PATENTANMELDUNG

(21) Anmeldenummer: 88120676.7

(22) Anmeldetag: 10.12.88

(51) Int. Cl.⁴: **C04B 35/00 , H01L 39/12 , H01L 39/24 , B32B 18/00**

(30) Priorität: 23.12.87 DE 3743753

(43) Veröffentlichungstag der Anmeldung:
28.06.89 Patentblatt 89/26

(84) Benannte Vertragsstaaten:
CH DE FR GB LI SE

(71) Anmelder: **Asea Brown Boveri Aktiengesellschaft Kallstadter Strasse 1 D-6800 Mannheim 31(DE)**

(72) Erfinder: **Rohr, Franz Josef, Dr. Forstweg 2 D-6941 Absteinach(DE)**
Erfinder: **Reich, Andreas Alstadter Strasse 55 D-6900 Heidelberg(DE)**

(74) Vertreter: **Rupprecht, Klaus, Dipl.-Ing. et al c/o Asea Brown Boveri Aktiengesellschaft Zentralbereich Patente Postfach 100351 D-6800 Mannheim 1(DE)**

(54) Verfahren zur Herstellung eines Supraleiters.

(57) Die Erfindung bezieht sich auf ein Verfahren zur Herstellung eines Supraleiters (1) aus einem oxidkeramischen Werkstoff, der auf einen Träger (2) aufgetragen wird. Aufgabe der Erfindung ist es, den Supraleiter (1) an die Anforderungen anzupassen, die an ihn bei der Anwendung in der Energietechnik gestellt werden. Erfindungsgemäß wird für die Ausbildung des oxidkeramischen Werkstoffs als Basismaterial nur Yttriumoxid, Bariumperoxid und Kupferoxid verwendet, denen Zusätze beigemischt sind. Zur Reduzierung der Sinterzeit und Erhöhung der Dichte wird dem Basismaterial Wismutoxid beigemischt. Durch einen Zusatz von Zirkonoxychlorid bzw. Zirkonoxyfluorid wird eine Vergrößerung der Kristallite bewirkt und eine höhere Übergangstemperatur erreicht.

## Verfahren zur Herstellung eines Supraleiters

Die Erfindung bezieht sich auf ein Verfahren zur Herstellung eines Supraleiters gemäß dem Oberbegriff des Patentanspruches 1.

Supraleiter kommen vor allem in der Energietechnik zur Anwendung. Sie sind für die Weiterentwicklung im Bereich der Kernfusion, der supraleitenden Generatoren sowie dem Bau von Starkfeldmagneten erforderlich. Supraleiter werden vorzugsweise als Drähte, Fasern, Bänder, Folien, Rohre, Körper mit Kapillarstruktur oder Körper mit Wabenstruktur bzw. in Form von Platten ausgebildet. Seit langem werden Supraleiter aus Metallen der D-Metall-Reihe und aus Metallen, die am Anfang der P-Reihe stehen, hergestellt. Seit kurzem ist es auch möglich, Supraleiter aus keramischen Werkstoffen herzustellen. Es handelt sich dabei um oxidkeramische Materialien mit Perowskitstruktur, die supraleitende Eigenschaften aufweisen. Diese oxidkeramischen Werkstoffe werden auf einem metallischen oder nichtmetallischen Träger abgeschieden, der eine definierte mechanische Festigkeit und eine ausreichende Flexibilität aufweist. Bisher wurde bevorzugt Strontiumtitanat (SrTiO₃) für die Herstellung des Trägers verwendet.

Ein Nachteil der bisher verwendeten oxidkeramischen Werkstoffe mit supraleitenden Eigenschaften besteht darin, daß sie nicht den Anforderungen genügen, die bei den technischen Anwendungen an sie gestellt werden.

Der Erfindung liegt deshalb die Aufgabe zugrunde, ein Verfahren aufzuzeigen, mit dem ein Supraleiter aus einem oxidkeramischen Werkstoff mit einer höheren Übergangstemperatur und einem besseren Strom- und Magnetfeldverhalten hergestellt werden kann.

Diese Aufgabe wird erfindungsgemäß durch die Merkmale des Patentanspruches 1 gelöst.

Durch die Verwendung eines verbesserten oxidkeramischen Werkstoffs für die Ausbildung des Supraleiters wird sichergestellt, daß dessen supraleitende Schichten eine einwandfreie Perowskitstruktur mit orthorhombischem Kristallgitter aufweisen. Ferner verfügt der erfindungsgemäße Supraleiter über ein optimales keramisches Gefüge, d.h. die Kristallitgröße und deren Ausrichtung entsprechen den notwendigen Voraussetzungen. Das gleiche gilt für die Dichte des supraleitenden Materials.

Erfindungsgemäß wird für die Ausbildung des oxidkeramischen Werkstoffes neben Yttriumoxid und Kupferoxid ausschließlich Bariumperoxid (BaO₂) und kein Bariumcarbonat verwendet. Dies hat den Vorteil, daß auf eine längere Erhitzung des Ausgangsmaterials verzichtet werden kann, da BaO₂ schon bei einer Temperatur oberhalb 700° C in BaO + O₂ zerfällt, während für die Zersetzung von Bariumcarbonat in Gegenwart von Y₂O₃ und CuO eine Temperatur von 900 bis 950° C erforderlich ist. Die niedrigere Zersetzungstemperatur des BaO₂ erhöht die Sinteraktivität des Materials, so daß bei dem anschließenden Sinterprozeß bei wesentlich verkürzter Sinterdauer (ca.3 h) ein Supraleiter mit höherer Dichte und Stromtragfähigkeit gefertigt werden kann. Der bei der Zersetzung des Bariumperoxids freiwerdende Sauerstoff begünstigt ebenfalls die Supraleitereigenschaften, insbesondere die Ausbildung der orthorhombischen Kristallstruktur, sowie die Einstellung einer optimalen Sauerstoffstöchiometrie. Hierdurch wird die sonst übliche Nachbehandlung der supraleitenden Schichten, zur Erzielung dieser Eigenschaften überflüssig.

Dem Basismaterial, insbesondere den oxidischen Verbindungen von Yttrium, Barium und Kupfer wird als Zusatz Wismutoxid beigemischt. Durch diesen Zusatz wird die Dichte des supraleitenden Materials erhöht. Vorzugsweise werden 0,5 bis 3 Gew.% Wismutoxid bezogen auf die Gesamtmenge des Basismaterials als Zusatz verwendet. Durch diesen Zusatz wird es erreicht, daß die oxidischen Verbindungen von Yttrium, Barium und Kupfer nur mit einem Druck von 100 MPa verdichtet werden müssen, und anschließend bei 950° C nur drei Stunden lang an Luft zu sintern sind. Das Sintermaterial wird anschließend in einer Sauerstoffatmosphäre mit einer Abkühlgeschwindigkeit von 100° C pro Stunde auf 400° C bis 500° C abgekühlt und daraufhin 4 bis 16 Stunden lang bei dieser Temperatur getempert.

Trotz der kurzen Reaktions- und Sinterzeit sowie der relativ niedrigen Sintertemperatur werden durch den Zusatz von Wismutoxid im Vergleich zu anderen Verfahren ausreichende Dichten bei dem supraleitenden Material erzielt, die 92 bis 95 % der theoretisch ermittelten Dichte betragen.

Mit dem erfindungsgemäßen Verfahren wird durch einen weiteren Zusatz von Zirkonoxychlorid bzw. Zirkonoxyfluorid eine Verbesserung der supraleitenden Eigenschaften bewirkt. Durch diesen Zusatz können die Kristallitgröße und die Dichte sowie die Stromtragfähigkeit des supraleitenden Materials erhöht werden. Gleichzeitig wird eine Verschiebung der Übergangstemperatur zu einem größeren Wert erreicht. Erfindungsgemäß werden dem Basismaterial in Form von oxidischen Verbindungen des Yttriums, Bariums und des Kupfers 1 bis 10 Mol %, vorzugsweise 2 bis 6 Mol % Zirkonoxychlorid bzw. Zirkonoxyfluorid beigemischt. Bei Verwendung dieses Zusatzes kann die Menge des verwendeten Yttriumoxids um 2 bis 6 Mol % verringert werden. Erfindungsgemäß wird in dem sich ausbildenden orthorhombischen Kristallgitter zu einem kleinen Teil das Yttrium durch Zirkonium und Sauerstoff durch Fluor oder Chlor ersetzt. Hierdurch wird eine Vergrößerung der Perwoskitkristallite um das zehnfache der normalen Kantenlänge bewirkt. Gleichzeitig werden die gefügebedingten supraleitenden Eigenschaften verbessert.

Weitere erfindungswesentliche Merkmale sind in den Unteransprüchen gekennzeichnet.

Das Verfahren wird nachfolgend anhand einer Zeichnung erläutert.

Die einzige, zur Beschreibung gehörende Figur zeigt einen Supraleiter 1, der im wesentlichen durch einen Träger 2 und eine supraleitende Schicht 3 gebildet wird. Bei dem hier dargestellten Ausführungsbeispiel ist der Träger 2 als dünne Faser ausgebildet, und aus metallischen oder nichtmetallischen Werkstoffen wie z.B. einer Nickel/Chrom Legierung, Siliziumtitanat, Siliziumcarbid, Bor, Stahl, Aluminiumoxid oder Glas gefertigt. Der Träger 2 kann selbstverständlich auch als dünnes Band ausgebildet sein. Träger mit einer anderen Form sind ebenfalls möglich. Die supraleitende Schicht 3 ist unmittelbar auf die Oberfläche 2 F des Trägers 2 aufgetragen. Zur Ausbildung der supraleitenden Schicht 3 wird ein pulverförmiges, oxidkeramisches Material mit Perowskitstruktur hergestellt. Zur Ausbildung des oxidkeramischen Werkstoffs werden Yttriumoxid, Bariumperoxid und Kupferoxid verwendet. Alle drei Werkstoffe liegen in Pulverform vor. Diesen drei oxidischen Verbindungen, die das Basismaterial bilden, werden Zusätze beigemischt. Als Zusätze werden Wismutoxid oder Zirkonoxychlorid bzw. Zirkonoxyfluorid ($ZrOCl_2$ bzw. $ZrOF_2$) beigemischt. Die oxidischen Verbindungen von Yttrium, Barium und Kupfer werden in einem Mol-Verhältnis 1:2:3 miteinander gemischt. Der Zusatz an Wismutoxid beträgt 0,5 bis 3 Gew.% bezogen auf die Gesamtmenge des verwendeten Basismaterials. Zirkonoxychlorid bzw. Zirkonoxyfluorid wird in einer Menge von 1 bis 10 Mol %, vorzugsweise 2 bis 6 Mol % dem Basismaterial beigemischt. Bei Verwendung dieses Zusatzes kann die Menge des verwendeten Yttriumoxids um 2 bis 6 Mol % verringert werden. Die Zusätze liegen ebenfalls in Pulverform vor und werden zusammen mit dem Basismaterial in einer Schwingmühle gemischt und gemahlen. Das gutgemischte und gemahlene Pulver wird anschließend durch Pressen bei einem Druck von 100 MPa verdichtet. Der so gewonnene Werkstoff wird anschließend bei 950° C drei Stunden lang an Luft gesintert. Daraufhin wird das Sintermaterial in einer Sauerstoffatmosphäre langsam abgekühlt, und zwar mit einer Abkühlgeschwindigkeit von 100° C pro Stunde, bis eine Temperatur von etwa 400 bis 500° C erreicht ist. Auf dieser Temperatur wird der Werkstoff nun 4 bis 16 Stunden lang gehalten, je nach Temperatur, und dabei getempert. Zur Ausbildung des supraleitenden Materials wird der gesinterte und getemperte Werkstoff in eine Kugelmühle oder Schwingmühle gefüllt und zu einem feinkörnigen Pulver gemahlen. Vorzugsweise wird ein Pulver mit Korngrößen zwischen 23 und 220 μm hergestellt. Für die Weiterverarbeitung des Pulvers wird dieses zunächst nach Korngrößen getrennt. Zur Ausbildung von supraleitenden Schichten aus diesem Material werden vor allem Pulver mit einer Korngröße von 23 bis 64 μm, Pulver mit einer Korngröße zwischen 32 und 83 μm, sowie Pulver mit einer Korngröße zwischen 64 bis 120 μm und 120 und 220 μm benötigt. Nach der Fertigstellung des Pulvers wird dieses durch Plasmaspritzen auf die Oberfläche 2 F des Trägers 2 aufgetragen. Als Trägergas wird ein inertes Gas, beispielsweise Argon verwendet, dem Sauerstoff beigemischt ist. Die Menge des Sauerstoffs, die dem Trägergas beigemischt ist, richtet sich nach der Korngröße des zu verwendeten Pulvers. Ist die Korngröße groß, so ist die Sauerstoffkonzentration des Trägergases relativ niedrig. Bei Verwendung von sehr feinkörnigem Pulver in der Größenordnung von 23 bis 63 μm beträgt der Sauerstoffanteil des Trägergases 25 bis 40 % bezogen auf die Gesamtmenge des verwendeten Trägergases. Bei Verwendung von Pulvern mit einer Korngröße zwischen 63 und 125 μm beträgt der Sauerstoffanteil des Trägergases nur 15 bis 30 %. Es hat sich gezeigt, daß es von Vorteil ist, wenn der Träger 2 beim Aufbringen der supraleitenden Schicht 3 auf einer konstanten Temperatur von 400 bis 500° C gehalten wird. Hierdurch wird eine beständige Haftung der supraleitenden Schicht auf dem Träger 2 sichergestellt.

Nach dem Auftragen der supraleitenden Schicht auf die Oberfläche 2 F des Trägers 2 ist der Supraleiter 1 fertiggestellt.

Anstelle einer supraleitenden Schicht 3 können auch bei Bedarf mehrere solche Schichten übereinander aufgetragen werden. Die Anzahl der aufzutragenden supraleitenden Schichten 3 richtet sich nach der Haftfestigkeit des oxidkeramischen Werkstoffs auf dem Träger. Bei einer schlechten Haftfestigkeit ist es sinnvoll, mehrere sehr dünne Schichten 3 übereinander auf die Oberfläche 2 F des Trägers 2 aufzutragen.

Falls mit chemischen Reaktionen zwischen dem Material des Trägers 2 und dem oxidkeramischen Werkstoff zu rechnen ist, bzw. falls bei hohen oder tiefen Temperaturen Wechselwirkungen zwischen den Werkstoffen auftreten können, kann unmittelbar auf die Oberfläche 2 F des Trägers 2 eine Zwischenschicht (hier nicht dargestellt) aufgebracht werden. Diese wird vorzugsweise durch ein dotiertes Zirkoniumdioxid gebildet, wobei als Dotierungsmaterial Yttriumoxid bzw. Yttriumoxid und Ytterbiumoxid verwendet werden. Mischoxide mit Perowskitstruktur können ebenfalls zur Ausbildung einer Zwischenschicht verwendet werden.

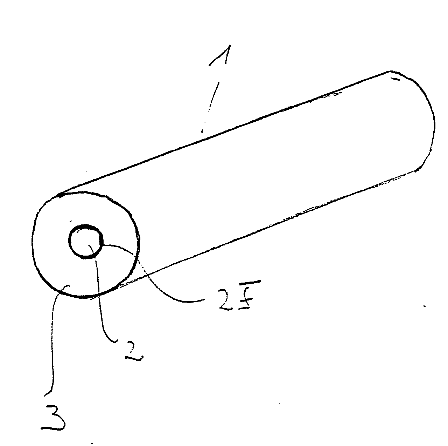

**Ansprüche**

1. Verfahren zur Herstellung eines Supraleiters (1) mit wenigstens einer supraleitenden Schicht (3) aus einem oxidkeramischen Werkstoff, der auf einen Träger (2) aufgetragen ist, dadurch gekennzeichnet, daß oxidische Verbindungen der Metalle, die den oxidkeramischen Werkstoff bilden, mit wenigstens einem Zusatzstoff gemischt, verdichtet und gesintert werden, und daß der gesinterte Werkstoff anschließend in einer Sauerstoffatmosphäre mit einer definierten Abkühlungsgeschwindigkeit auf eine vorgegebene Temperatur abgekühlt und bei dieser Temperatur getempert wird.

2. Verfahren nach Anspruch 1, dadurch gekennzeichnet, daß zur Ausbildung des oxidkeramischen Werkstoffs pulverförmiges Yttriumoxid, Bariumperoxid und Kupferoxid in einem Mol-Verhältnis von 1:2:3 mit 0,5 bis 3 Gew.% pulverförmigen Wismutoxid ($Bi_2O_3$) bezogen auf das Gesamtgewicht des verwendeten Basismaterials gemischt und gemahlen und bei einem Druck von 100 MPa verdichtet und daraufhin bei 950° C drei Stunden lang an Luft gesintert werden, und daß der gesinterte Werkstoff anschließend in einer Sauerstoffatmosphäre mit einer Abkühlgeschwindigkeit von 100° C pro Stunde auf 400 bis 500° C abgekühlt und bei dieser Temperatur 4 bis 16 Stunden lang getempert wird.

3. Verfahren nach einem der Ansprüche 1 oder 2, dadurch gekennzeichnet, daß zur Ausbildung des oxidkera mischen Werkstoffs den oxidischen Verbindungen von Yttrium, Barium und Kupfer als weiterer Zusatz 1 bis 10 Mol %, vorzugsweise 2 bis 6 Mol %, pulverförmiges Zirkonoxychlorid oder Zirkonoxyfluorid ($ZrOCl_2$ oder $ZrOF_2$) beigemischt werden, und daß bei Verwendung dieses Zusatzes der Anteil des Yttriumoxids am Basismaterial um 2 bis 6 Mol % reduziert wird.

4. Verfahren nach einem der Ansprüche 1 bis 3, dadurch gekennzeichnet, daß zur Ausbildung der supraleitenden Schicht (3) der gesinterte und getemperte Werkstoff zu einem feinkörnigem Pulver mit Korngrößen von 23 bis 220 μm gemahlen wird, und daß das so gewonnene Pulver mittels Plasmaspritzen unter Verwendung von Argon als Trägergas auf die Oberfläche (2 F) des Trägers (2) aufgetragen wird.

5. Verfahren nach einem der Ansprüche 1 bis 4, dadurch gekennzeichnet, daß zur Ausbildung der supraleitenden Schicht (3) ein Träger (2) aus Metall, einer Legierung oder einer Keramik verwendet wird, und daß beim Auftragen der supraleitenden Schicht (2) dem Trägergas 15 bis 40 % Sauerstoff in Abhängigkeit von der Korngröße des verwendeten oxidkeramischen Pulvers beigemischt wird.

6. Verfahren nach Anspruch 5, dadurch gekennzeichnet, daß der Träger (2) aus einer Ni-Cr-Legierung, Stahl, Aluminiumoxid, $ZrO_2/Y_2O_3$, MgO, $MgAl_2O_3$ oder Mg-Al-Silikat gefertigt ist.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X,P | JOURNAL OF SOLID STATE CHEMISTRY, Band 73, 7. März 1988, Seiten 610-614, Academic Press, Inc.; G. FEREY et al.: "Ordered Pd2+-Cu2+ substitution in 1.2.3. superconductor: The oxide Yba2Cu(3-x)PdxOy (x∿0.5) with Pd2+ in square planar coordination" * Seite 611 * | 1 | C 04 B 35/00 H 01 L 39/12 H 01 L 39/24 B 32 B 18/00 |
| A | IDEM --- | 5-6 | |
| A | ADVANCED CERAMIC MATERIALS, Band 2, Nr. 3B, "Special Issue", Juli 1987, Seiten 471-479, American Ceramic Soc.; W.J. WEBER et al.: "Synthesis and characterization of YBa2Cu3O7-x superconductors" * Seite 472 * ----- | 1-6 | |
| | | | **RECHERCHIERTE SACHGEBIETE (Int. Cl.4)** C 04 B H 01 L B 32 B |

Der vorliegende Recherchenbericht wurde für alle Patentansprüche erstellt

| Recherchenort | Abschlußdatum der Recherche | Prüfer |
|---|---|---|
| DEN HAAG | 04-04-1989 | LUETHE H. |